(19) Europäisches Patentamt
European Patent Office
Office européen des brevets

(11) **EP 3 709 481 B1**

(12) **FASCICULE DE BREVET EUROPEEN**

(45) Date de publication et mention de la délivrance du brevet:
**27.12.2023 Bulletin 2023/52**

(21) Numéro de dépôt: **20162727.0**

(22) Date de dépôt: **12.03.2020**

(51) Classification Internationale des Brevets (IPC):
*H02J 50/12* (2016.01)    *B60L 53/12* (2019.01)
*B60L 53/67* (2019.01)    *H02J 50/40* (2016.01)
*B60L 53/30* (2019.01)    *B60L 53/39* (2019.01)
*B60M 3/04* (2006.01)    *B60L 5/00* (2006.01)
*G01R 31/42* (2006.01)    *H02J 7/00* (2006.01)
*B60M 7/00* (2006.01)    *B60L 5/42* (2006.01)
*B60L 53/14* (2019.01)    *B60L 53/36* (2019.01)

(52) Classification Coopérative des Brevets (CPC):
**H02J 50/12; B60L 5/005; B60L 5/42; B60L 53/14;
B60L 53/36; B60L 53/39; B60M 7/003;
G01R 31/42; H02J 50/402;** H02J 50/60;
H02J 2310/48; Y02T 10/70; Y02T 10/7072;
Y02T 90/12; Y02T 90/14

(54) **PROCÉDÉ DE GESTION D'UN SYSTÈME DE CHARGE SANS CONTACT ET SYSTÈME DE CHARGE SANS CONTACT**

STEUERVERFAHREN EINES KONTAKTLOSEN AUFLADESYSTEMS, UND ENTSPRECHENDES KONTAKTLOSES AUFLADESYSTEM

METHOD FOR MANAGING A CONTACTLESS CHARGING SYSTEM AND CONTACTLESS CHARGING SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.03.2019 FR 1902664**

(43) Date de publication de la demande:
**16.09.2020 Bulletin 2020/38**

(73) Titulaire: **Renault s.a.s**
**92100 Boulogne Billancourt (FR)**

(72) Inventeurs:
• **LOUDOT, Serge**
**91190 villiers le bacle (FR)**

• **CAILLEREZ, Antoine**
**92310 Sèvres (FR)**

(74) Mandataire: **Renault Group**
**Renault s.a.s.**
**1 avenue du Golf**
**FR TCR AVA 055**
**78084 Guyancourt Cedex (FR)**

(56) Documents cités:
**FR-A1- 3 045 231**     **US-A1- 2014 097 674**
**US-A1- 2018 201 139**

EP 3 709 481 B1

**Description**

La présente invention concerne la gestion de systèmes de charge sans contact pour des véhicules automobiles à propulsion électrique ou hybride électrique.

Des systèmes de charge sans contact pour véhicules automobiles à propulsion électrique ou hybride électrique comprennent de manière classique un réseau de bobines primaires successives disposées dans un tronçon de route. Les bobines primaires assurent un transfert de puissance par induction avec une bobine secondaire équipant un véhicule automobile et reliée à une batterie électrique de traction du véhicule. On pourra par exemple se reporter au document FR 3 045 231 qui décrit un exemple d'un tel système.

Dans le document FR 3 045 231, il est mis en oeuvre un transfert de puissance entre une bobine primaire et le véhicule puis un transfert de puissance entre une bobine primaire suivante et le véhicule. La bobine primaire suivante est mise en court-circuit avant la transition entre le transfert de puissance incluant la bobine primaire et le transfert de puissance incluant la bobine primaire suivante. De la sorte, la bobine primaire suivante utilise le flux magnétique produit par la bobine primaire pour détecter la position du véhicule qui arrive. Il est ainsi mis en oeuvre une gestion de la charge du véhicule en se passant de capteur de la position du véhicule.

Un inconvénient de cette solution est lié au fait que les bobines primaires sont disposées dans le tronçon de route sous la couche de roulement. De ce fait, les bobines primaires ne peuvent être remplacées que lorsque la route est rénovée, soit tous les 10 à 15 ans environ. Il existe donc un risque qu'une bobine primaire du système soit défaillante.

Avec le procédé de gestion du document FR 3 045 231, si une bobine primaire est défaillante, l'activation par récurrence de la succession de bobines primaires est interrompue à partir de la bobine défaillante. La portion du système de charge située en aval de la bobine défaillante est alors rendue hors service.

Le document FR 3 045 231 enseigne par ailleurs, en cas de perte anormale de transfert de puissance due à une bobine primaire défaillante, la reprise du transfert de puissance sur une bobine primaire située en aval de la dernière bobine ayant émis. Pour ce faire, les bobines primaires situées en aval de la dernière bobine ayant émis sont mises en court-circuit et la bobine secondaire équipant le véhicule est alimentée. Un train d'impulsions émis par la bobine secondaire est détecté par la première bobine primaire fonctionnelle située en aval de la dernière bobine ayant émis. La charge reprend alors en évitant la bobine primaire défaillante.

Toutefois, une telle solution est relativement compliquée et ne permet pas de confirmer l'information qu'une bobine est définitivement défaillante.

L'invention a pour but de pallier les inconvénients précités.

Plus particulièrement, l'invention a pour but de fournir un procédé de gestion d'un système de charge sans contact permettant l'identification d'une défaillance d'une bobine primaire de manière robuste.

A cet effet, il est proposé un procédé de gestion d'un système de charge sans contact comprenant un réseau doté d'au moins deux bobines successives disposées dans un tronçon de route, le procédé comprenant une phase d'identification d'une défaillance du système de charge, la phase d'identification comprenant les étapes de :

- alimentation en courant électrique d'une première bobine choisie parmi les bobines du réseau,
- mise en court-circuit d'au moins une deuxième bobine choisie parmi les bobines du réseau et différente de la première bobine, engendrant la réception d'un courant induit dans l'au moins deuxième bobine dû à un transfert de puissance par induction provenant de la première bobine,
- détermination d'un paramètre électrique de ladite première bobine et de ladite deuxième bobine, et
- comparaison du paramètre déterminé avec au moins une valeur seuil.

Dans ce procédé, la phase d'identification permet d'identifier de manière robuste la défaillance de l'une des bobines du réseau sans requérir l'ajout de composant matériel supplémentaire.

Dans un mode de mise en oeuvre, le réseau comprend au moins trois bobines successives, la première bobine occupant une position centrale parmi les bobines du réseau.

De la sorte, on met en oeuvre la phase d'identification de manière économe en énergie et rapide.

Dans un autre mode de réalisation, le procédé comprend au moins deux itérations de la phase d'identification en choisissant, à chaque itération, une première bobine différente parmi les bobines successives du réseau.

Un tel mode de mise en oeuvre permet d'augmenter la robustesse de l'identification d'une défaillance en recoupant les différents résultats.

On peut en outre prévoir que l'étape de détermination comprend la mesure d'un courant traversant la deuxième bobine.

On identifie de la sorte de manière simple et robuste la défaillance de la(des) deuxième(s) bobine(s).

Avantageusement, l'étape de détermination comprend la détermination d'une impédance d'un dipôle comprenant la première bobine.

De la sorte, on peut identifier une dérive de composant lié à la première bobine.

Avantageusement, l'étape d'alimentation comprend l'alimentation électrique de la première bobine à une fréquence type de résonance prédéfinie.

La fréquence de résonance étant généralement la même, aux dispersions près, pour toutes les bobines du réseau, et l'impédance d'une bobine mise en court-circuit étant très faible à la fréquence de résonance, le courant alimentant la première bobine est du même ordre de grandeur que le(s) courant(s) induit(s) dans la(les) deuxième(s) bobine(s).

Avantageusement, l'étape d'alimentation comprend un balayage fréquentiel de l'alimentation de la première bobine.

Le balayage augmente la robustesse de l'identification d'une défaillance. Il permet notamment de déterminer précisément la fréquence d'accord de la bobine alimentée (par le maximum de courant) et, de ce fait, de détecter une dérive de cette fréquence qui peut être stockée en mémoire lors des divers balayages.

Dans un mode de mise en oeuvre, l'étape de détermination comprend l'établissement d'une courbe d'un paramètre électrique de la première bobine en fonction de la fréquence d'alimentation de la première bobine.

L'analyse de la courbe, par exemple au moyen d'un gabarit approprié, permet de distinguer si la défaillance est une dérive de composant lié à la première bobine ou la présence d'un corps étranger sur la chaussée.

Dans un mode de mise en oeuvre, le procédé comprend une phase de réglage comportant la modification d'un seuil de démarrage d'une bobine réglée en fonction d'une défaillance identifiée d'une bobine adjacente à la bobine réglée.

La phase de réglage permet, en cas de bobine défaillante, d'adapter la gestion du système pour assurer de manière plus simple et plus fluide une continuité de la charge par les autres bobines.

Selon un autre aspect, il est proposé un système de charge sans contact comprenant un réseau doté d'au moins deux bobines successives disposées dans un tronçon de route, et un dispositif de gestion comprenant un module d'identification d'une défaillance du système de charge, le module d'identification comprenant :

- un bloc d'alimentation apte à alimenter une première bobine choisie parmi les bobines successives du réseau en courant électrique,
- un bloc de mise en court-circuit apte à mettre en court-circuit au moins une deuxième bobine choisie parmi les bobines successives du réseau et différente de la première bobine,
- un bloc de détermination d'un paramètre électrique de la deuxième bobine, dépendant d'un courant induit dans la deuxième bobine par la première bobine, et
- un comparateur apte à comparer un paramètre déterminé par le bloc de détermination avec au moins une valeur seuil.

D'autres buts, caractéristiques et avantages de l'invention apparaîtront à la lecture de la description suivante, donnée uniquement à titre d'exemple non limitatif, et faite en référence aux dessins annexés sur lesquels :

[Fig 1] est une vue d'ensemble d'un système de charge sans contact selon un aspect de l'invention,

[Fig 2] est une vue schématique du dispositif de gestion du système de charge de la figure 1,

[Fig 3]

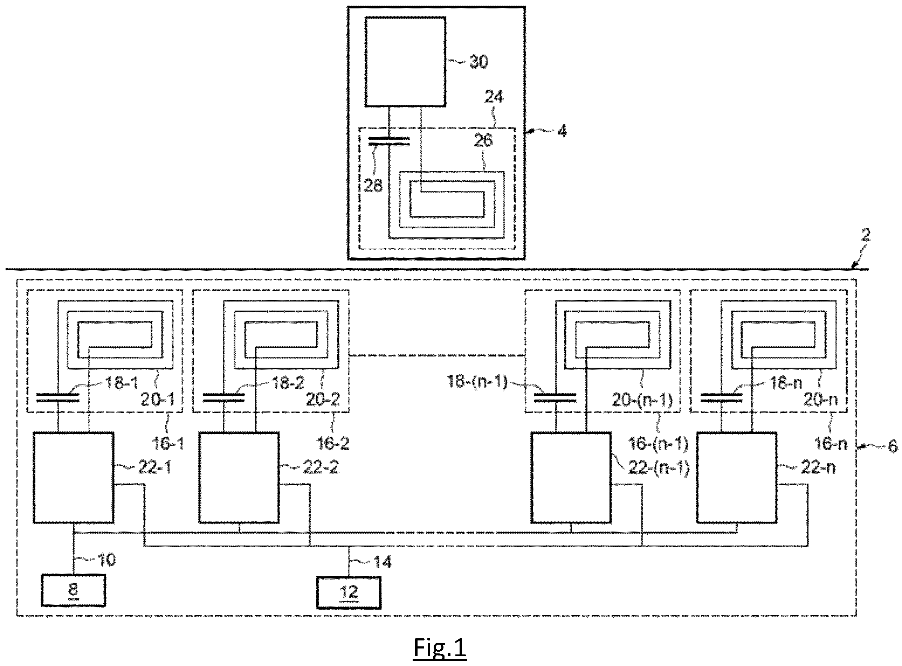

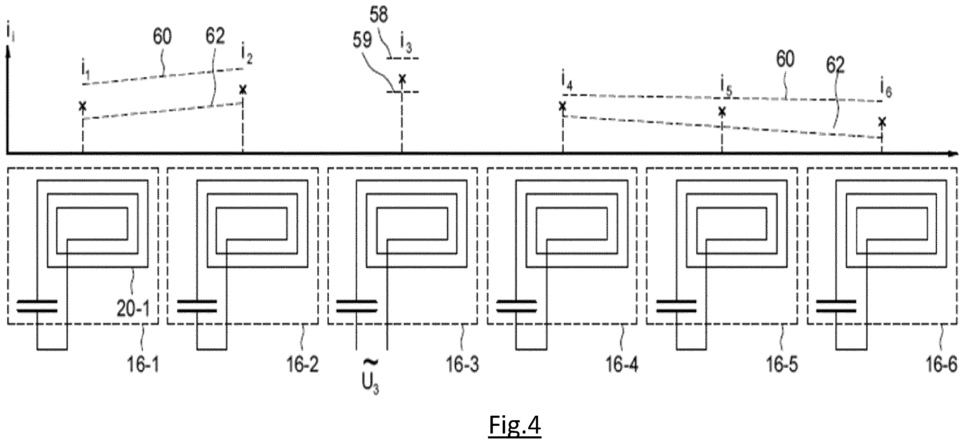

[Fig 4] sont deux vues du système de charge de la figure 1 lors de deux itérations distinctes d'une phase d'identification,

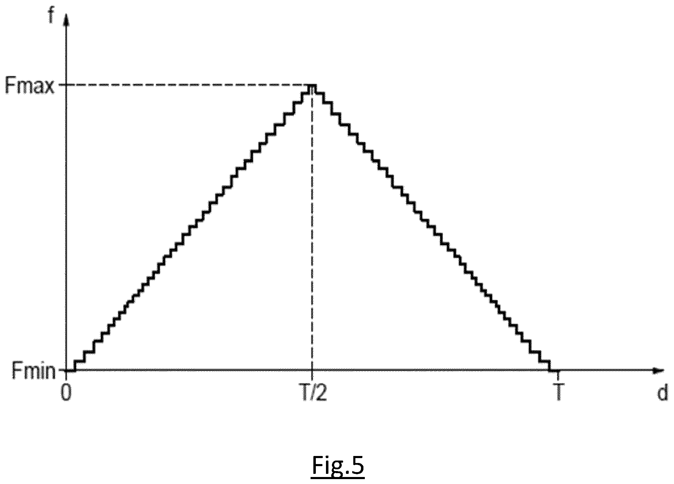

[Fig 5] est une représentation graphique d'un balayage séquentiel du courant d'alimentation, et

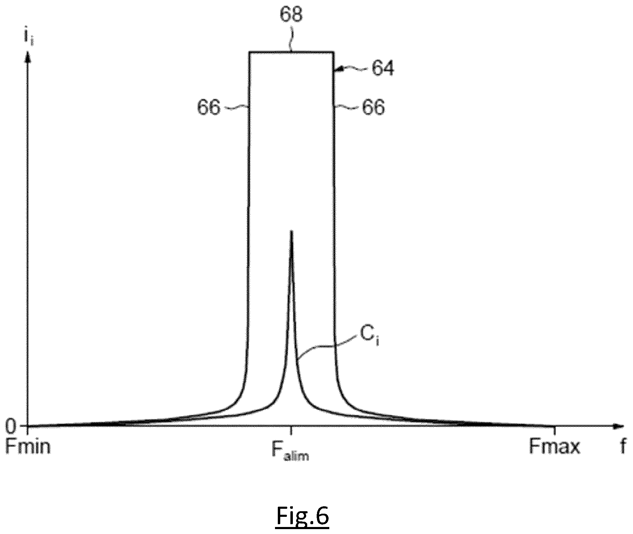

[Fig 6] est une représentation graphique d'un gabarit de comparaison pouvant être associé à une bobine du système de charge de la figure 1.

En référence à la figure 1, on a schématiquement représenté une route 2 et un véhicule automobile 4 circulant sur la route 2. Le véhicule automobile 4 est à propulsion électrique.

Un système de charge sans contact 6 est incorporé dans un tronçon de la route 2. Le système 6 permet le transfert de puissance par induction au véhicule 4 en vue de recharger une batterie électrique de traction (non représentée) équipant le véhicule 4.

Le système 6 comporte une unité d'alimentation électrique 8. L'unité 8 peut être une prise électrique reliée à un secteur électrique (non représenté). L'unité 8 est connectée électriquement à un bus d'alimentation 10.

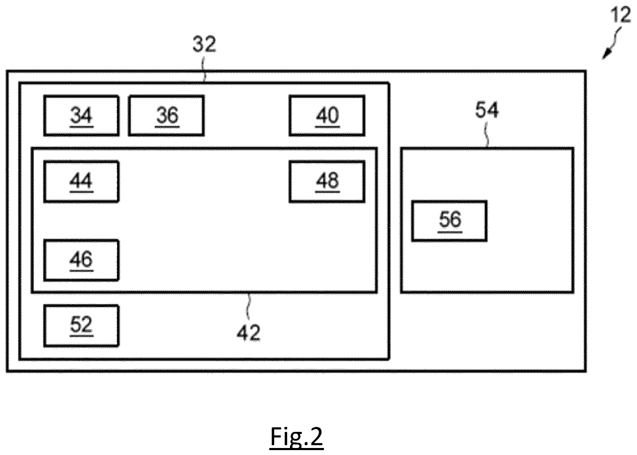

Le système 6 comporte un dispositif de gestion 12. Le dispositif 12 a pour fonction de gérer la charge du véhicule 4 par le système 6. Le dispositif 12 sera détaillé par la suite en référence à la figure 2. Le dispositif 12 est en liaison d'information avec un bus de terrain 14.

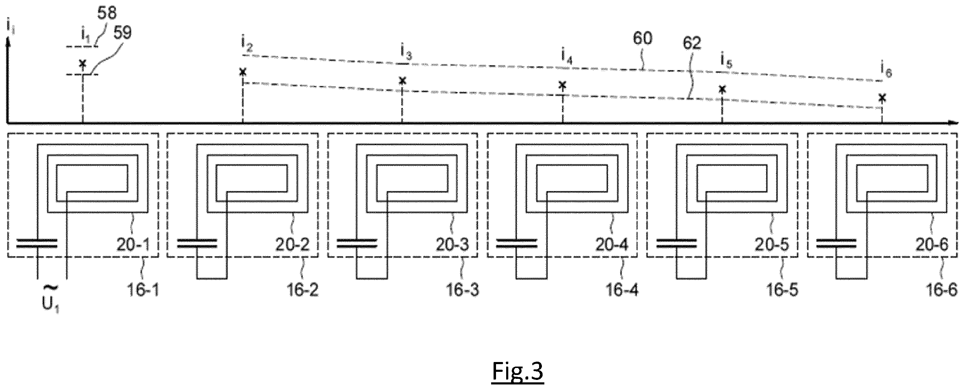

Le système 6 comporte une pluralité, en l'espèce n dipôles 16-1 à 16-n. Sur la vue schématique de la figure 1, seuls les quatre dipôles 16-1, 16-2, 16-(n-1) et 16-n sont représentés. Sur les vues des figures 3 et 4, on suppose que la valeur n est égale à 6 et les dipôles 16-1 à 16-6 sont représentés.

Quel que soit un nombre entier i compris entre 1 et n, le dipôle 16-i comprend un condensateur 18-i et une bobine primaire 20-i montés en série, la tension aux bornes du dipôle 16-i est notée Ui et l'intensité traversant un composant 18-i ou 20-i du dipôle 16-i est notée ii.

Quel que soit un nombre entier i compris entre 1 et n, un dipôle 16-i est électriquement connecté à un onduleur 22-i. Les onduleurs 22-1 à 22-n sont électriquement connectés avec le bus d'alimentation 10 et en liaison d'information avec le bus de terrain 14. De ce fait, l'unité d'alimentation 8 peut fournir de l'énergie électrique aux bobines 20-1 à 20-n et le dispositif 12 peut piloter l'alimentation électrique des bobines 20-1 à 20-n.

Le véhicule 4 comporte un dipôle 24 comprenant une bobine secondaire 26 et un condensateur 28. Le véhicule 4 comporte un onduleur 30 électriquement connecté au dipôle 24 d'une part et à une batterie électrique de traction équipant le véhicule 4 d'autre part.

En référence à la figure 2, le dispositif 12 comprend un module d'identification 32. Le module 32 a pour fonction d'identifier une défaillance de l'une des bobines 20-1 à 20-n.

Le module 32 comprend un bloc d'itération 34. Le bloc 34 a pour fonction de piloter le module 32 de sorte à mettre en oeuvre n itérations iter-1 à iter-n. A chaque itération, le bloc 34 choisit une première bobine distincte des premières bobines choisies pour les autres itérations. Dans le même temps, le bloc 34 choisit au moins une deuxième bobine différente de la première bobine. En l'espèce, quel que soit un nombre entier i compris entre 1 et n, au début de l'itération iter-i, le bloc 34 choisit la bobine 20-i comme la première bobine et les bobines {20-k/k≠i} comme les deuxièmes bobines. Comme cela sera expliqué par la suite, dans la présente demande, l'expression « première bobine » désigne une bobine primaire qui sera alimentée lors d'une phase d'identification d'une défaillance du système 6 et l'expression « deuxième bobine » désigne une bobine primaire qui sera mise en court-circuit au cours de cette phase d'identification.

Le module 32 comporte un bloc d'alimentation 36. Le bloc 36 est en liaison d'information avec l'unité 8 et avec les onduleurs 22-1 à 22-n. De ce fait, le bloc 36 peut modifier l'alimentation électrique de chacune des bobines 20-1 à 20-n. En particulier, le bloc 36 est doté des moyens matériels et logiciels pour alimenter une bobine 20-i en puissance électrique à une tension $U_i$ connue et à une fréquence $f_{alim}$ proche de la fréquence de résonance typique d'une bobine de ce type et de sa capacité de compensation associée.

Le module 32 comporte un bloc de mise en court-circuit 40. Le bloc 40 est en liaison d'information avec les onduleurs 22-1 à 22-n. De ce fait, le bloc 40 est capable de mettre en court-circuit chacun des dipôle 16-1 à 16-n.

Le module 32 comporte un bloc de détermination 42. Le bloc 42 a pour fonction de déterminer des paramètres électriques des bobines 20-1 à 20-n. A cet effet, le bloc 42 comprend un capteur d'intensité 44 et un capteur de tension 46. Le capteur 44 est capable de mesurer les intensités $i_i$ :

$$\{i_i / i \in [\![1, n]\!]\}$$

Le capteur 46 est capable de mesurer les tensions $U_i$ :

$$\{U_i / i \in [\![1, n]\!]\}$$

Le bloc 42 comporte un estimateur 48. L'estimateur 48 est apte à déterminer les impédances $Z_1$ à $Z_n$ des dipôles 16-1 à 16-n. Pour ce faire, l'estimateur 48 applique l'équation :

$$\forall i \in [\![1, n]\!], Z_i = \frac{U_i}{i_i}$$

Le module 32 comporte un comparateur 52. Le comparateur 52 a pour fonction de comparer les paramètres électriques déterminés par le bloc 42 avec des valeurs seuils prédéfinies. Les valeurs seuils seront détaillées par la suite en référence aux figures 3 et 4.

Le dispositif 12 comporte un module de réglage 54. Le module 54 a pour fonction de modifier le réglage du système 6 en fonction de l'identification d'une défaillance par le module 32.

A cet effet, le module 54 comprend un bloc de modification 56. Le bloc 56 est en liaison d'information avec les onduleurs 22-1 à 22-n. Le bloc 56 est apte à modifier le réglage de l'un quelconque des onduleurs 22-1 à 22-n de manière à modifier un seuil de démarrage d'une bobine 20-1 à 20-n respectivement associée.

On décrit maintenant un procédé de gestion du système 6 pouvant être mis en oeuvre au moyen du dispositif 12. Le procédé est initialisé à un instant auquel aucun véhicule ne circule sur le tronçon de la route 2 correspondant à la position des bobines 20-1 à 20-n. Si tel est le cas, le procédé commence par une phase d'identification.

Au cours de la phase d'identification, le bloc 34 définit une première itération iter-1 représentée sur la figure 3. Ce faisant, le bloc 34 choisit la bobine 20-1 comme la première bobine et les bobines 20-2 à 20-n comme les deuxièmes bobines.

Le bloc 36 alimente la première bobine 20-1 avec la tension $U_1$ à la fréquence $f_{alim}$. Dans le même temps, le bloc 40 met les deuxièmes bobines 20-2 à 20-6 en court-circuit. Par transfert de puissance par induction, le courant $i_2$ est induit dans la bobine 20-2. Le courant $i_2$ produit à son tour un flux magnétique partagé par la bobine 20-3 qui va également induire un courant $i_3$ et ainsi de suite sur tout le tronçon. Les courants $i_1$ à $i_6$ et l'impédance $Z_1$ de la bobine 20-1 sont recueillis par le bloc 42. Ensuite, le comparateur 52 compare l'amplitude de l'intensité $i_1$ avec une valeur de seuil supérieur et une valeur de seuil inférieur schématiquement représentées sur la figure 3 par les lignes pointillées 58 et 59 respectives. Le comparateur 52 compare aussi l'impédance $Z_1$ avec une valeur de seuil supérieur. Quel que soit un nombre entier i compris entre 2 et 6, le comparateur 52 compare également l'intensité $i_i$ avec une valeur de seuil supérieur et une valeur de seuil inférieur schématiquement représentées par les lignes pointillées 60 et 62 respectives. Si le comparateur 52 relève que l'amplitude du courant $i_1$ est hors du gabarit défini par les lignes 58 et 59, la bobine 20-1 est considérée comme défaillante. Pour l'impédance $Z_1$ et pour l'amplitude des courants $i_2$ à $i_6$, le comparateur 52 stocke les résultats dans une mémoire.

Le bloc 34 définit ensuite les itérations suivantes. En référence à 1a figure 4, lorsque l'itération iter-3 est mise en oeuvre, la bobine 20-3 est devenue la première bobine et les bobines 20-1, 20-2, 20-4 à 20-6 sont devenues les deuxièmes bobines. Ainsi, le bloc 36 alimente la première bobine 20-3 avec une tension $U_3$ à la fréquence $f_{alim}$ tandis que le bloc 40 met les deuxièmes bobines 20-1, 20-2, 20-4 à 20-6 en court-circuit. Le comparateur 52 compare l'amplitude de l'intensité $i_3$ au gabarit défini par les lignes 58 et 59 et considère la bobine 20-3 comme défaillante si l'amplitude est hors du gabarit. Le comparateur 52 compare l'impédance $Z_3$ de la bobine 20-3 avec le seuil supérieur correspondant et l'amplitude des intensités $i_1$, $i_2$, $i_4$ à $i_6$ avec les seuils schématiquement représentés par les lignes pointillées 60 et 62 et stocke ces résultats dans une mémoire. Le bloc 34 définit ensuite les itérations suivantes jusqu'à l'itération iter-6.

Lorsque toutes les itérations ont été mises en oeuvre, quel que soit un nombre entier i choisi entre 1 et 6, la bobine 20-i est considérée comme défaillante si l'impédance $Z_i$ s'est trouvée au-dessus de la valeur seuil supérieure et s'il existe au moins deux itérations distinctes de l'itération iter-i dans lesquelles le courant ii s'est trouvé en dehors du gabarit défini par les lignes 60 et 62.

A l'issue de la phase d'identification, si une bobine 20-k a été identifiée comme défaillante, une phase de réglage de la bobine 20-(k+1) est mise en oeuvre. Au cours de la phase de réglage, le seuil de démarrage de la bobine 20-(k+1) est réduit au prorata de l'atténuation mesurée entre les intensités $i_{k+1}$ et $i_{k-1}$.

Dans l'exemple illustré, il est réalisé autant d'itérations que le système 6 comprend de bobines primaires. Toutefois, on peut bien entendu sans sortir du cadre de l'invention envisager un nombre d'itérations différent de n, voire envisager de ne réaliser qu'une seule itération en définissant une bobine centrale, c'est-à-dire la bobine 20-j où :

$$j = Int\left(\frac{n}{2}\right)$$

où Int correspond à la fonction partie entière.

Par ailleurs, on peut sans sortir du cadre de l'invention envisager d'autre modes d'alimentation de la première bobine qu'un courant alternatif à la fréquence $f_{alim}$. Par exemple, à chaque itération iter-i, un balayage de fréquence du courant d'alimentation ii de la première bobine 20-i peut être mis en oeuvre. Le balayage peut être mis en oeuvre par une unité de balayage (non représentée) incorporée dans le bloc 36. Un exemple de balayage fréquentiel de l'alimentation d'une bobine 20-1 à 20-n est représenté sur la figure 5. Dans l'exemple de la figure 5, une bobine 20-i est alimentée par un courant d'alimentation ii pendant une durée T à une fréquence f. Au cours de la première moitié de la durée T, la fréquence f augmente par incréments depuis une fréquence minimale $F_{min}$ jusqu'à une fréquence maximale $F_{max}$. La fréquence f diminue ensuite de manière symétrique au cours de la seconde moitié de la durée T.

Lorsqu'un tel balayage est mis en oeuvre, on peut par ailleurs utiliser un gabarit plus précis que les gabarits schématisés sur les figures 3 et 4 par les lignes 58, 59, 60 et 62. En référence à la figure 6, quels que soit un entier i compris entre 1 et n, le bloc 42 établit une courbe Ci de l'amplitude de l'intensité ii à l'itération iter-i en fonction de la fréquence f. Par la suite, le comparateur 52 compare les courbes Ci à une courbe 64 formant un gabarit et centrée sur la fréquence $f_{alim}$. L'utilisation de la courbe 64 permet de distinguer une sortie du gabarit par les côtés verticaux 66 ou une sortie du gabarit par le côté horizontal 68.

Dans le premier cas, on identifie un décalage de la fréquence de résonance de la bobine 20-i correspondant à une dérive de composants du dipôle 16-i.

Dans le second cas, on identifie une augmentation de l'intensité ii sans décalage de la fréquence de résonance. On identifie de la sorte la présence d'un corps étranger conductif sur la chaussée. En effet, le corps étranger conductif forme une résistance en parallèle qui génère une augmentation de l'intensité ii.

Bien que ces identifications soient mises en oeuvre en utilisant une courbe Ci décrivant l'amplitude du courant ii, on peut bien entendu sans sortir du cadre de l'invention envisager l'utilisation d'une courbe décrivant l'impédance $Z_i$ du dipôle 16-i et d'un gabarit formé par une valeur de seuil inférieur variable.

Lorsque le gabarit utilisé par le comparateur 52 est capable d'identifier une défaillance correspondant à une dérive de composants d'un dipôle 16-i, on peut modifier le réglage de l'onduleur 22-i afin de compenser le déplacement de la fréquence de résonance de l'intensité ii. A cet égard, le module 54 peut comprendre un second bloc (non représenté) en liaison d'information avec les onduleurs 22-1 à 22-n et capable de mettre en oeuvre cette modification du réglage.

Au vu de ce qui précède, l'invention permet d'identifier de manière robuste la défaillance d'une bobine primaire d'un circuit de charge sans contact. En outre, l'invention permet de distinguer différents types de défaillance et de modifier le réglage du système pour améliorer la réponse aux défaillances identifiées.

**Revendications**

1. Procédé de gestion d'un système de charge sans contact (6) comprenant un réseau doté d'au moins deux bobines (20-1, ..., 20-n) successives disposées dans un tronçon de route (2), le procédé comprenant une phase d'identification d'une défaillance du système de charge (6), la phase d'identification comprenant les étapes de :

   - alimentation en courant électrique d'une première bobine choisie parmi les bobines (20-1, ..., 20-n) du réseau,
   - mise en court-circuit d'au moins une deuxième bobine choisie parmi les bobines du réseau (20-1, ..., 20-n) et différente de la première bobine, engendrant la réception d'un courant induit dans l'au moins deuxième bobine dû à un transfert de puissance par induction provenant de la première bobine,

- détermination d'un paramètre électrique de ladite première bobine et de ladite deuxième bobine, et

- comparaison du paramètre déterminé avec au moins une valeur seuil.

2. Procédé selon la revendication 1, dans lequel le réseau comprend au moins trois bobines successives, la première bobine occupant une position centrale parmi les bobines (20-1, ..., 20-n) du réseau.

3. Procédé selon la revendication 1, comprenant au moins deux itérations (iter-1, ..., iter-6) de la phase d'identification en choisissant, à chaque itération, une première bobine différente parmi les bobines (20-1, ..., 20-n) successives du réseau.

4. Procédé selon l'une quelconque des revendications 1 à 3, dans lequel l'étape de détermination comprend la mesure d'un courant traversant la deuxième bobine.

5. Procédé selon l'une quelconque des revendications 1 à 4, dans lequel l'étape de détermination comprend la détermination d'une impédance d'un dipôle comprenant la première bobine.

6. Procédé selon l'une quelconque des revendications 1 à 5, dans lequel l'étape d'alimentation comprend l'alimentation électrique de la première bobine à une fréquence type de résonance ($f_{alim}$) prédéfinie.

7. Procédé selon l'une quelconque des revendications 1 à 6, dans lequel l'étape d'alimentation comprend un balayage fréquentiel de l'alimentation de la première bobine.

8. Procédé selon la revendication 7, dans lequel l'étape de détermination comprend l'établissement d'une courbe d'un paramètre électrique de la première bobine en fonction de la fréquence d'alimentation de la première bobine.

9. Procédé selon l'une quelconque des revendications 1 à 8, comprenant une phase de réglage comportant la modification d'un seuil de démarrage d'une bobine réglée (20-(k+1)) en fonction d'une défaillance identifiée d'une bobine (20-k) adjacente à la bobine réglée (20-(k+1)).

10. Système de charge sans contact (6) comprenant un réseau doté d'au moins deux bobines (20-1, ..., 20-n) successives disposées dans un tronçon de route (2), et un dispositif de gestion (12) comprenant un module d'identification (24) d'une défaillance du système de charge (6), le module d'identification (24) comprenant :

- un bloc d'alimentation (36) apte à alimenter une première bobine choisie parmi les bobines (20-1, ..., 20-n) successives du réseau en courant électrique,

- un bloc de mise en court-circuit (40) apte à mettre en court-circuit au moins une deuxième bobine choisie parmi les bobines (20-1, ..., 20-n) successives du réseau et différente de la première bobine,

- un bloc de détermination (42) d'un paramètre électrique de la deuxième bobine, dépendant d'un courant induit dans la deuxième bobine par la première bobine, et

- un comparateur (52) apte à comparer le paramètre déterminé par le bloc de détermination (42) avec au moins une valeur seuil.

**Patentansprüche**

1. Steuerverfahren eines kontaktlosen Aufladesystems (6), das ein Netzwerk aus mindestens zwei aufeinanderfolgenden Spulen (20-1, ..., 20-n), die in einem Streckenabschnitt (2) angeordnet sind, beinhaltet, wobei das Verfahren eine Phase des Identifizierens einer Störung des Aufladesystems (6) beinhaltet, wobei die Phase des Identifizierens die folgenden Schritte beinhaltet:

- Versorgen einer ersten Spule, die aus den Spulen (20-1, ..., 20-n) des Netzwerks ausgewählt wird, mit elektrischem Strom,

- Kurzschließen mindestens einer zweiten Spule, die aus den Spulen (20-1, ..., 20-n) des Netzwerks ausgewählt wird und sich von der ersten Spule unterscheidet, sodass aufgrund einer Leistungsübertragung durch Induktion von der ersten Spule die Aufnahme eines induzierten Stroms in mindestens der zweiten Spule bewirkt wird,

- Bestimmen eines elektrischen Parameters der ersten Spule und der zweiten Spule und

- Vergleichen des bestimmten Parameters mit mindestens einem Schwellenwert.

2. Verfahren nach Anspruch 1, wobei das Netzwerk mindestens drei aufeinanderfolgende Spulen beinhaltet, wobei die erste Spule eine zentrale Position innerhalb der Spulen (20-1, ..., 20-n) des Netzwerks einnimmt.

3. Verfahren nach Anspruch 1, das mindestens zwei Iterationen (iter-1, ..., iter-6) der Phase des Identifizierens beinhaltet, wobei bei jeder Iteration eine unterschiedliche Spule aus den aufeinanderfolgenden Spulen (20-1, ..., 20-n) des Netzwerks ausgewählt wird.

4. Verfahren nach einem beliebigen der Ansprüche 1 bis 3, wobei der Schritt des Bestimmens die Messung eines Stroms beinhaltet, der durch die zweite Spule fließt.

5. Verfahren nach einem beliebigen der Ansprüche 1 bis 4, wobei der Schritt des Bestimmens das Bestimmen einer Impedanz eines Dipols, der die erste Spule beinhaltet, beinhaltet.

6. Verfahren nach einem beliebigen der Ansprüche 1 bis 5, wobei der Schritt des Versorgens die elektrische Versorgung der ersten Spule mit einer vordefinierten Frequenz vom Typ Resonanzfrequenz ($f_{alim}$) beinhaltet.

7. Verfahren nach einem beliebigen der Ansprüche 1 bis 6, wobei der Schritt des Versorgens eine Frequenzabtastung der Versorgung der ersten Spule beinhaltet.

8. Verfahren nach Anspruch 7, wobei der Schritt des Bestimmens die Erstellung einer Kurve eines elektrischen Parameters der ersten Spule in Abhängigkeit von der Versorgungsfrequenz der ersten Spule beinhaltet.

9. Verfahren nach einem beliebigen der Ansprüche 1 bis 8, das eine Regelungsphase beinhaltet, die das Modifizieren einer Startschwelle einer geregelten Spule (20-(k+1)) in Abhängigkeit von einer identifizierten Störung einer Spule (20-k), die zu der geregelten Spule (20-(k+1)) benachbart ist, beinhaltet.

10. Kontaktloses Aufladesystem (6), das ein Netzwerk aus mindestens zwei aufeinanderfolgenden Spulen (20-1, ..., 20-n), die in einem Streckenabschnitt (2) angeordnet sind, und eine Steuervorrichtung (12), die ein Modul zum Identifizieren (24) einer Störung des Aufladesystems (6) beinhaltet, beinhaltet, wobei das Identifizierungsmodul (24) Folgendes beinhaltet:

- einen Versorgungsblock (36), der dazu fähig ist, eine erste Spule, die aus den aufeinanderfolgenden Spulen (20-1, ..., 20-n) des Netzwerks ausgewählt wird, mit elektrischem Strom zu versorgen,
- einen Kurzschlussblock (40), der dazu fähig ist, mindestens eine zweite Spule, die aus den aufeinanderfolgenden Spulen (20-1, ..., 20-n) des Netzwerks ausgewählt wird und sich von der ersten Spule unterscheidet, kurzzuschließen,
- einen Block zum Bestimmen (42) eines elektrischen Parameters der zweiten Spule, der von einem Strom abhängt, der durch die erste Spule in der zweiten Spule induziert wird, und
- einen Komparator (52), der dazu fähig ist, den durch den Bestimmungsblock (42) bestimmten Parameter mit mindestens einem Schwellenwert zu vergleichen.

## Claims

1. Method for managing a contactless charging system (6) comprising a network provided with at least two successive coils (20-1, ..., 20-n) arranged in a road section (2), the method comprising a phase of identifying a failure of the charging system (6), the identification phase comprising the steps of:

- supplying electrical current to a first coil chosen from the coils (20-1, ..., 20-n) of the network,
- short-circuiting at least a second coil chosen from the coils (20-1, ..., 20-n) of the network other than the first coil, resulting in an induced current being received in the at least second coil due to a transfer of power by induction coming from the first coil,
- determining an electrical parameter of said first coil and of said second coil, and
- comparing the determined parameter with at least one threshold value.

2. Method according to Claim 1, wherein the network comprises at least three successive coils, the first coil occupying a central position amongst the coils (20-1, ..., 20-n) of the network.

3. Method according to Claim 1, comprising at least two iterations (iter-1, ..., iter-6) of the identification phase while choosing, at each iteration, a different first coil from the successive coils (20-1, ..., 20-n) of the network.

4. Method according to any one of Claims 1 to 3, wherein the determination step comprises measuring a current flowing through the second coil.

5. Method according to any one of Claims 1 to 4, wherein the determination step comprises determining an impedance of a dipole comprising the first coil.

6. Method according to any one of Claims 1 to 5, wherein the power supply step comprises supplying electrical power to the first coil at a predefined standard resonance frequency ($f_{alim}$).

7. Method according to any one of Claims 1 to 6, wherein the power supply step comprises scanning the frequency of the power supply to the first coil.

8. Method according to Claim 7, wherein the determination step comprises establishing a curve of an electrical parameter of the first coil as a function of the frequency of the power supply to the first coil.

9. Method according to any one of Claims 1 to 8, comprising an adjustment phase comprising modifying a threshold for starting an adjusted coil (20-(k+1)) as a function of an identified failure of a coil (20-k) adjacent to the adjusted coil (20-(k+1)).

10. Contactless charging system (6) comprising a network provided with at least two successive coils (20-1, ..., 20-n) arranged in a road section (2), and a management device (12) comprising a module (24) for identifying a failure of the charging system (6), the identification module (24) comprising:

   - a power supply unit (36) able to supply electrical current to a first coil chosen from the successive coils (20-1, ..., 20-n) of the network,
   - a short-circuiting unit (40) able to short-circuit at least a second coil chosen from the successive coils (20-1, ..., 20-n) of the network other than the first coil,
   - a unit (42) for determining an electrical parameter of the second coil, depending on a current induced in the second coil by the first coil, and
   - a comparator (52) able to compare the parameter determined by the determination unit (42) with at least one threshold value.

Fig.1

Fig.2

58
59
$i_1$
$i_2$
$i_3$
$i_4$
60
62
$i_5$
$i_6$

20-1
20-2
20-3
20-4
20-5
20-6

$\tilde{U}_1$

16-1
16-2
16-3
16-4
16-5
16-6

Fig.3

Fig.4

EP 3 709 481 B1

Fig.5

Fig.6

EP 3 709 481 B1

## RÉFÉRENCES CITÉES DANS LA DESCRIPTION

**Documents brevets cités dans la description**

- FR 3045231